Europäisches Patentamt

European Patent Office

Office européen des brevets

(19)

(11) **EP 1 060 499 B1**

(12) **FASCICULE DE BREVET EUROPEEN**

(45) Date de publication et mention
de la délivrance du brevet:
**05.06.2002 Bulletin 2002/23**

(21) Numéro de dépôt: **99907657.3**

(22) Date de dépôt: **03.03.1999**

(51) Int Cl.$^7$: **H01J 37/317**, G03F 7/20

(86) Numéro de dépôt international:
**PCT/FR99/00477**

(87) Numéro de publication internationale:
**WO 99/45566 (10.09.1999 Gazette 1999/36)**

(54) **DISPOSITIF ET PROCEDE DE FORMATION DE MOTIFS DE LITHOGRAPHIE UTILISANT UN INTERFEROMETRE**

VORRICHTUNG UND VERFAHREN ZUR LITHOGRAPHISCHEN MUSTERERZEUGUNG MITTELS EINEM INTERFEROMETER

DEVICE AND METHOD FOR FORMING LITHOGRAPHIC PATTERNS USING AN INTERFEROMETER

(84) Etats contractants désignés:
**DE FR GB IT**

(30) Priorité: **04.03.1998 FR 9802622**

(43) Date de publication de la demande:
**20.12.2000 Bulletin 2000/51**

(73) Titulaire: **COMMISSARIAT A L'ENERGIE ATOMIQUE**
**75015 Paris (FR)**

(72) Inventeurs:
• **BRUEL, Michel**
**F-38113 Veurey (FR)**
• **BAPTIST, Robert**
**F-38560 Jarrie (FR)**

(74) Mandataire: **Weber, Etienne Nicolas et al c/o Brevatome,**
**3, rue du Docteur Lancereaux**
**75008 Paris (FR)**

(56) Documents cités:
**DE-A- 4 331 468**       **FR-A- 2 365 881**
**US-A- 5 415 835**       **US-A- 5 466 548**

• **PATENT ABSTRACTS OF JAPAN vol. 095, no. 005, 30 juin 1995 & JP 07 045506 A (RES DEV CORP OF JAPAN), 14 février 1995**
• **PATENT ABSTRACTS OF JAPAN vol. 016, no. 336 (E-1237), 21 juillet 1992 & JP 04 100212 A (NIPPON TELEGR & TELEPH CORP), 2 avril 1992**

EP 1 060 499 B1

**Description**

Domaine technique

L'invention concerne un dispositif de lithographie et un procédé permettant de former des motifs de lithographie dans une couche sensible.

L'invention trouve des applications notamment dans les domaines de la micro-électronique, la micro-mécanique et l'optique, pour la réalisation de microstructures ou de nanostructures, c'est-à-dire de structures dont les dimensions, très petites, se situent dans une gamme allant de quelques nanomètres à quelques dizaines de micromètres.

L'invention peut être mise en oeuvre, par exemple, dans la fabrication de dispositifs tels que des transistors mono-électron, des boîtes quantiques, des fils quantiques, ou des réseaux de diffraction pour rayons X.

Etat de la technique antérieure

La réalisation des structures de micro-électronique ou de micro-mécanique associe des techniques de lithographie à des techniques de dépôt de matériau, de gravure de matériau, de dopage, d'oxydation, etc...

Les techniques de lithographie permettent la mise en forme de couches de matériau, telle qu'en particulier des couches de résine photosensible. Ces couches de résine servent ensuite à graver ou éliminer sélectivement des parties d'autres couches sous-jacentes ou sus-jacentes.

Les couches sensibles, telles que la résine photosensible, sont soumises à un faisceau d'exposition à travers un masque optique. Ce masque présente des motifs d'exposition, de façon à n'exposer, ou insoler, que des parties sélectionnées de la couche sensible. Les parties sélectionnées correspondent soit aux motifs que l'on souhaite pratiquer dans la couche sensible, soit à des parties complémentaires des motifs que l'on souhaite réaliser.

Enfin, un développement de la couche sensible permet d'éliminer les parties insolées (résine positive) ou au contraire les parties non insolées (résine négative).

Il s'avère cependant que ces techniques de lithographie, connues, sont incompatibles avec les dimensions de certaines nanostructures et certaines microstructures que l'on souhaite réaliser, et incompatibles avec les contraintes liées à la production industrielle de dispositifs incluant de telles structures.

En particulier, les techniques usuelles de lithographie sont inadaptées à la réalisation industrielle de structures telles que des réseaux de rainures ou de bandes parfaitement rectilignes, agencées selon un pas très fin.

Pour réaliser des motifs plus fins, on connaît des procédés dans lesquels on fait passer le faisceau d'exposition par un interféromètre tel qu'un biprisme de Möllenstedt, pour exposer la couche sensible selon un motif d'interférence.

Le biprisme de Möllenstedt est capable de séparer le faisceau d'électrons en deux faisceaux et de défléchir ces faisceaux de façon qu'ils se recouvrent et forment une figure d'interférence.

Les deux faisceaux émis par un biprisme de Möllenstedt se comportent comme s'ils étaient émis par deux sources fictives, et le pas D des franges d'interférence électronique obtenues est tel que $D = \lambda . \frac{L}{a}$, où "λ" est la longueur d'onde électronique, "L" la distance séparant la couche de matériau sensible et les sources fictives, et "a" la distance séparant les sources fictives entre elles.

Les documents (1), (2), (3), (4), (5) et (6), dont les références sont précisées à la fin de la présente description, donnent une description plus détaillée de l'interférométrie électronique.

Le biprisme est construit pour l'essentiel autour d'un fil polarisé. L'interférence produit des franges d'interférence modulées en intensité, parallèles au fil polarisé du biprisme. Par analogie avec l'interférence optique une frange "brillante" correspond à une frange où les électrons atteignent la cible et une frange "sombre" correspond à une frange où les électrons n'atteignent pas la cible.

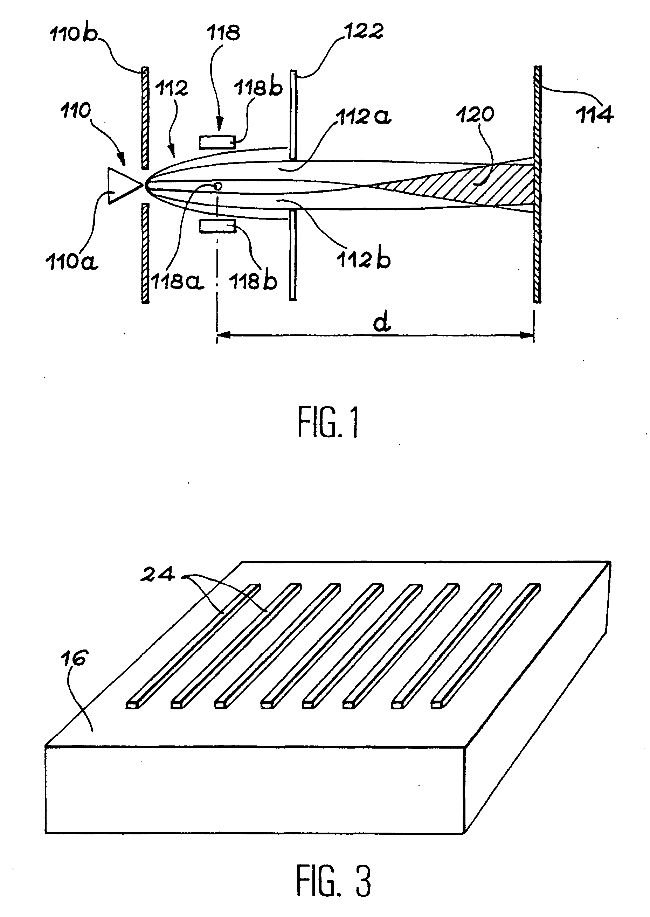

La figure 1 montre un dispositif de lithographie utilisant un biprisme tel que décrit.

Une source d'électrons ponctuelle 110 est formée par une cathode à micropointe 110a et une grille d'extraction 110b. L'énergie des électrons d'un faisceau 112 émis par la source 110 est fonction de la tension appliquée entre la cathode à micropointe 110a et la grille d'extraction 110b.

Un interféromètre 118, du type de Möllenstedt comporte un fil 118a (vu en coupe), et des plaques équipotentielles 118b. Le fil 118a, polarisé, sépare le faisceau 112 en deux moitiés de faisceau 112a et 112b.

Une déflexion de ces faisceaux permet de former une zone d'interférence 120 et de former sur une couche sensible 114, qui constitue une anode, des franges d'interférence. Cette déflexion est obtenue en ajustant la différence de potentiel entre le fil 118a et les plaques 118b.

La couche sensible est par exemple une résine sensible du type utilisé de façon connue dans les opérations de lithographie avec un masqueur électronique (électron beam pattern generator).

La référence 122 désigne un diaphragme délimitant le champ d'interférence donc d'insolation.

Le tableau I ci-après indique en fonction de l'énergie des électrons, du diamètre du fil polarisé 118a et de la distance d entre le fil polarisé et la surface sensible, la valeur de l'interfrange.

TABLEAU I

| ENERGIE ET LONGUEUR D'ONDE DU FAISCEAU D'ELECTRONS | DIAMETRE DU FIL (µm) | DISTANCE FIL/ANODE | INTERFRANGE (µm) |
|---|---|---|---|
| E=50eV λ=0,17 nm | 0,1 | 1 cm | 17 µm |
| E=50eV λ=0,17 nm | 0,1 | 1 mm | 1,7 µm |
| E=50eV λ=0,17 nm | 0,1 | 10 µm | 0,017 µm |
| E=100eV λ=0,11 nm | 0,1 | 10µm | 12 nm |

L'interfrange, c'est-à-dire la distance d'axe à axe entre deux franges (brillantes ou sombres) consécutives est maximum lorsque les deux faisceaux 112a et 112b défléchis commencent à se superposer. Lorsque la tension de polarisation, appliquée au fil 118a est augmentée, les faisceaux 112a et 112b se courbent, se superposent davantage et la valeur de l'interfrange diminue.

La valeur de l'interfrange dépend pour l'essentiel de l'énergie des électrons, du diamètre du fil 118a, de la distance d, et de la polarisation appliquée au fil et aux plaques 118b. Une augmentation du diamètre du fil risque cependant de cacher une partie du champ exposé en raison de l' "ombre" du fil qui est alors plus grande.

Le développement consiste à baigner (ou arroser) les plaquettes portant la résine insolée dans (avec) un bain chimique qui peut être du type basique

ou solvant. Cette opération permet de dissoudre les parties insolées de la résine dans le cas d'une résine positive, et de dissoudre les parties non-insolées dans le cas d'une résine négative.

Exposé de l'invention

La présente invention a pour but de proposer un procédé et un dispositif différents de ceux décrits ci-dessus, permettant de réaliser de façon industrielle des composants comportant des structures fines dont les dimensions et/ ou le pas sont compris entre quelques nanomètres et quelques micromètres.

Un but est encore de proposer un tel procédé permettant de réaliser des structures fines de très grande longueur, par exemple de l'ordre d'une dizaine de centimètres.

Enfin, un but est de proposer un dispositif plus simple et plus fiable que le biprisme décrit ci-dessus.

Pour atteindre ces buts, l'invention a plus précisément pour objet un procédé de formation de motifs de lithographie dans une couche sensible par soumission de cette couche à au moins un faisceau d'exposition. Conformément à l'invention, le procédé comporte au moins une étape lors de laquelle on fait passer le faisceau d'exposition par un interféromètre pour exposer la couche sensible selon un motif d'interférence qui est un réseau de franges, dites franges de "moiré", l'interféromètre étant équipé d'au moins deux réseaux de diffraction périodiques superposés ayant un pas et/ou une orientation différents.

Le procédé de l'invention peut combiner l'utilisation de plusieurs faisceaux d'exposition, ces derniers pouvant être utilisés soit simultanément, soit successivement.

Le procédé peut, notamment dans le cas où la couche sensible est une couche de résine photosensible, être complété par un développement de la couche sensible pour mettre en forme les motifs de lithographie selon le motif d'interférence.

Selon un aspect particulier de l'invention, le faisceau d'exposition peut être un faisceau de photons ou un faisceau d'électrons. Le faisceau de photons peut comprendre notamment des rayons X, des U.V., des rayons dans le visible, l'infrarouge.

Le motif d'interférence se présente sous la forme d'un réseau de franges d'aspect moiré. Les franges sont dite franges de "moiré".

Pour une description plus détaillée des franges de moiré, obtenues notamment à partir de rayons X, on peut se reporter aux documents (8) et (9) dont les références sont précisées à la fin de la présente description.

Comme indiqué ci-dessus, pour obtenir des franges de "moiré" on utilise un interféromètre comportant deux ou plusieurs réseaux périodiques associés. Les franges de "moiré" sont le résultat d'un phénomène d'interférence qui se produit lorsqu'une onde électromagnétique se propage successivement à travers deux réseaux périodiques.

Les deux réseaux périodiques peuvent présenter des pas différents. Dans ce cas, les réseaux sont agencés de préférence de façon à présenter sensiblement la même orientation.

Les deux réseaux peuvent aussi présenter des pas identiques. Ils sont alors agencés de préférence de façon à présenter des orientations angulairement décalées.

Le pas des réseaux de l'interféromètre peut être ajusté en fonction de la longueur d'onde du faisceau d'exposition de façon à être, de préférence, du même ordre de grandeur.

Selon un aspect particulier de l'invention, on peut utiliser un interféromètre dont les réseaux périodiques sont formés par des réseaux atomiques de matériaux cristallins.

Ces réseaux ont l'avantage de présenter un pas de l'ordre de grandeur de la fraction de nanomètre. Ainsi, les franges de "moiré" obtenues peuvent présenter un pas ajustable entre des valeurs inférieures au nanomètre, jusqu'à plusieurs dizaines de micromètres, par exemple.

Le pas des franges de "moiré" est en effet toujours supérieur au pas des réseaux.

Le pas des franges est indépendant de la longueur d'onde du rayonnement qui traverse l'interféromètre mais peut être ajusté en modifiant le pas des réseaux ou en modifiant l'orientation relative des réseaux qui composent l'interféromètre.

A titre d'exemple, dans le cas où deux réseaux composant l'interféromètre présentent le même pas d, le pas des franges de "moiré", noté D, est relié au pas d des réseaux par la relation suivante.

$$D=\frac{d}{\theta}.$$

Dans cette formule, qui est valable pour des faibles valeurs de $\theta$, $\theta$ représente l'angle, mesuré en radians, entre les orientations des réseaux. Pour des angles $\theta$ plus grands, l'expression de la relation entre le pas des franges de "moiré" et les pas des réseaux est plus complexe.

Le document (10), dont la référence est indiquée à la fin de la présente description, illustre l'obtention de franges de "moiré" présentant un pas de 17 $\mu$m, à partir de plaquettes de silicium dont l'orientation est décalée d'un angle de 2,5 sec.

Dans un autre exemple, concernant l'utilisation d'un interféromètre avec deux réseaux de pas différents, notés d1 et d2, mais présentant la même orientation ($\theta=0$), le pas D des franges de "moiré" est tel que :

$$D = \frac{d_1 \cdot d_2}{d_1 - d_2}$$

Pour la réalisation d'interféromètres comportant deux réseaux de pas différents mais orientés de la même façon, on peut utiliser des plaquettes de matériaux cristallins différents. On peut aussi utiliser des cristaux du même matériau et appliquer à l'un des cristaux une contrainte supplémentaire par rapport à l'autre cristal afin de faire légèrement varier le pas de son réseau.

La contrainte peut être une contrainte externe exercée par l'application au cristal de forces de tension ou de compression. Elle peut également être une contrainte interne. Une telle contrainte interne peut être générée par l'introduction d'impuretés dans le cristal, par diffusion ou implantation, ou encore par création de défauts cristallins par bombardement ionique.

L'invention concerne également un dispositif de lithographie pour appliquer sur une couche sensible au moins un faisceau d'exposition. Conformément à l'invention, le dispositif comporte un interféromètre disposé entre une source du faisceau d'exposition et la couche sensible, pour former dans la couche sensible un motif d'interférence qui est un réseau de franges de "moiré", l'interféromètre comportant au moins deux réseaux périodiques de diffraction superposés ayant un pas et/ou une orientation différents.

Comme indiqué précédemment, le faisceau d'exposition peut être un faisceau d'électrons ou un faisceau de photons (visible, UV, X, ...).

La source du faisceau d'exposition peut être une source d'électrons comportant une cathode à émission de champ telle qu'une cathode à micropointe.

D'autres caractéristiques et avantages de la présente invention ressortiront mieux de la description qui va suivre, en référence aux figures des dessins annexés. Cette description est donnée à titre purement illustratif et non limitatif.

Brève description des figures

- La figure 1, déjà décrite, est une représentation schématique, en coupe, d'un dispositif utilisant une source d'électrons pour réaliser des franges d'interférence à l'aide d'un biprisme de Möllenstedt.
- Les figures 2A et 2B sont des représentations schématiques de dispositifs de lithographie conformes à l'invention, utilisant une source de photons.

- La figure 3 montre un substrat comportant un réseau de bandes parallèles obtenu conformément à l'invention.

Description détaillée de modes de mise en oeuvre de l'invention

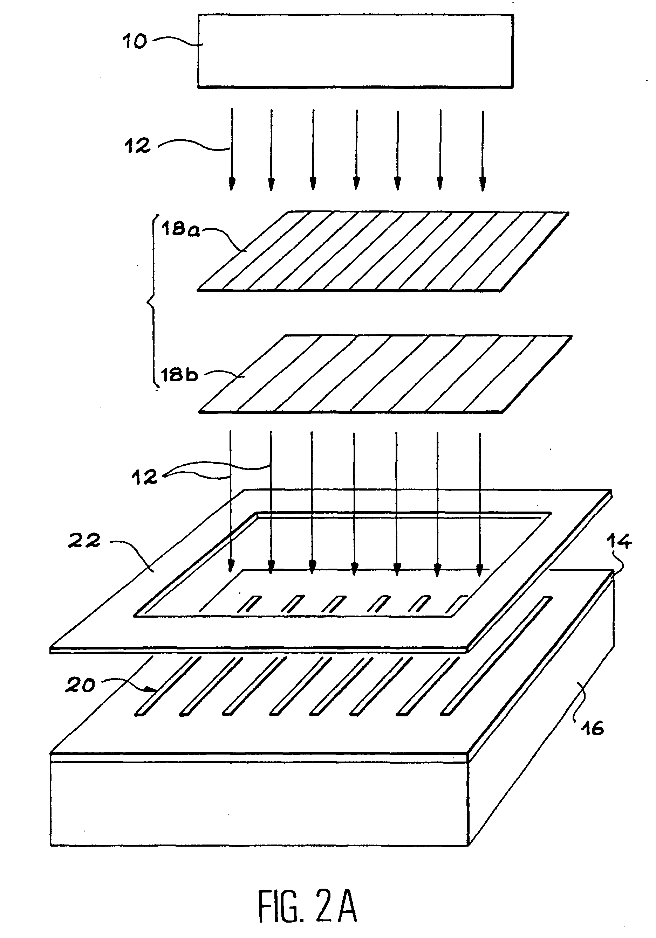

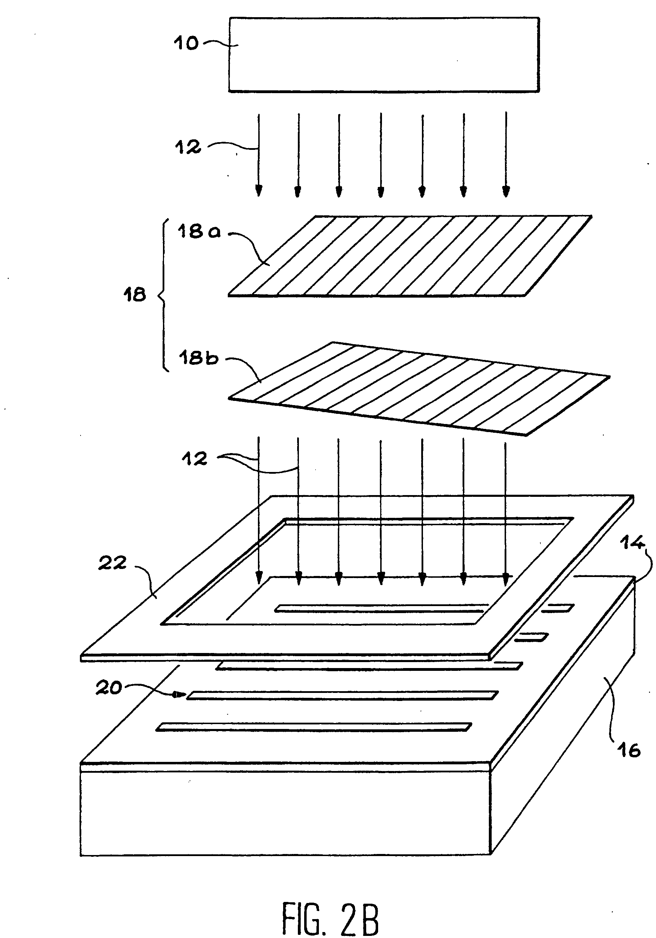

La figure 2A montre de façon schématique les principaux éléments d'un dispositif de lithographie conforme à l'invention.

La référence 10 indique une source de photons de forte intensité capable d'émettre un faisceau large 12 tel que des rayons X.

Le faisceau 12 de rayons X, émis par la source, 10 peut être généré par exemple à partir d'un faisceau primaire d'électrons fourni par un synchrotron.

Selon des variantes, la source 10 peut être remplacée par une source émettant un faisceau d'électrons.

Le faisceau 12 est dirigé vers la surface d'une couche superficielle 14 de matériau sensible à la longueur d'onde du rayonnement de la source 10. La couche de matériau sensible est, par exemple, une couche de résine photosensible formée sur un substrat 16.

Toutefois, avant d'atteindre la surface de la couche de matériau sensible, le faisceau 12 traverse un interféromètre 18 formé par exemple par deux plaques 18a, 18b de matériau cristallin (deux plaques très fines (~ quelques centaines de nm dans le cas où on utilise des électrons)).

Le faisceau incident 12 est diffracté deux fois à travers les deux réseaux 18a et 18b.

Cette diffraction forme avec la partie du faisceau transmis sans diffraction une figure d'interférence avec des franges. En d'autres termes, la traversée de l'interféromètre 18 permet de former sur la couche du matériau sensible 14 une figure d'interférence 20 composée d'une alternance de franges "brillantes", recevant le rayonnement, et de franges "sombres". Ces franges sont des franges de "moiré" telles que décrites précédemment.

Dans l'exemple de la figure 2A, les deux réseaux périodiques 18a et 18b présentent des pas légèrement différents, mais sont alignés, c'est-à-dire parallèles l'un à l'autre.

On peut noter que la matériau sensible de la couche superficielle 14 peut être exposé plusieurs fois, en modifiant par exemple l'orientation du substrat lors de chaque exposition.

Les franges d'interférence obtenues lors des différentes expositions peuvent être croisées afin de réaliser, par exemple, un motif selon un réseau orthogonal ou carré.

Par ailleurs, un masque 22 peut être prévu entre la source 10 du faisceau d'exposition et la couche de matériau sensible. Le masque 22 permet d'occulter des parties sélectionnées de la couche sensible 14 sur lesquelles on ne souhaite pas former de figure d'interférence. En particulier, le masque peut comporter des motifs d'exposition correspondant à des structures que l'on souhaite réaliser sur la couche sensible. Ainsi, un tel masque permet de combiner le procédé de l'invention avec les techniques classiques de la lithographie.

La figure 2B montre une variante du dispositif de la figure 2A dans lequel sont utilisés deux réseaux de pas identique mais présentant un léger décalage angulaire entre eux.

On observe que des franges de "moiré" différentes sont obtenues.

Les réseaux 18a et 18b peuvent être des réseaux d'atomes. Ils comportent alors des cristaux agencés selon des plans parallèles. Les paramètres de maille des cristaux formant les réseaux 18a et 18b peuvent être choisis légèrement différents et/ou l'orientation des plans parallèles peut être légèrement décalée de façon à former un angle. Les matériaux utilisés pour les deux réseaux peuvent être identiques ou différents.

Il convient de préciser que les caractéristiques des figures 2A et 2B peuvent être combinées, c'est-à-dire deux réseaux de pas différents peuvent être en outre disposés de façon à présenter un léger décalage angulaire.

La figure 3 montre le substrat 16 après un développement de la couche de résine photosensible.

Dans l'exemple représenté, la résine est une résine positive, et le développement de la résine permet de dissoudre toutes les parties qui n'ont pas été exposées.

On obtient ainsi sur le substrat 16 un réseau de fils 24, parallèles et très fins.

Le procédé de l'invention permet de réaliser de tels fils de grande longueur permettant de "couvrir" un substrat d'un diamètre de 300 mm.

Les fils fins 24 peuvent à leur tour être utilisés comme masque de gravure pour mettre en forme des couches sous-jacentes du substrat 16.

La formation de franges d'interférence peut être obtenue, dans une autre mise en oeuvre particulière de l'invention, avec une source ponctuelle d'électrons.

**DOCUMENTS CITES**

**(1)**

"Construction d'un interféromètre électronique pour l'étude des propriétés émissives de micropointes à effet de champ. Diffraction et interférence d'électrons lents", par C. Py, These de Doctorat (Physique) Université Joseph Fourier-Grenoble 1 ( 1993).
ou
"Low-energy electron interference with Spindt-type microtips" par C. Py et R. Baptist, J. Vac. Sci. Technol. B 13 (2), Mar/Apr 1995

**(2)**

"Electron interferometry and interference electron microscopy. PAR G.F. Missiroli, G. Pozzi and U. Valdré, J. Phys. E Sci. Instrum, vol. 14 (1981), p. 649-670.

**(3)**

"Interferometrie electronique à basse énergie" par W. Lai, Thèse de Doctorat (Sciences des matériaux), Université Aix-Marseille III (1997);

**(4)**

"Practical Electron Microscopy in Materials Science-Monograph Three", pages 80 à 84 de J. W. Edingt-on - Macmillan/Philips Technical Library.

**(5)**

DE-A-4 331 468

**(6)**

US-A-5 466 548

**(7)**

US-A-5 415 835

**(8)**

"X-ray MOIRE fringes topography of lattice defects in quartz"
par A.R. Lang, NATURE, vol. 220, Novembre 16, 1968, pages 652,657.

**(9)**

"The years of X-Ray interferometry", par M. Hart, Proc. R. Soc. Lond. A. 346, 1-22 (1975)

**(10)**

"Use of the Ewald sphere in aligning crystal pairs to produce X-ray moire fringes
par J. Bradler et A. R. Lang, Acta Crystallographica, vol. A24, 1968, pages 245 à 247.

**Revendications**

1. Procédé de formation de motifs de lithographie dans une couche (14) de matériau sensible par soumission de cette couche à au moins un faisceau d'exposition (12), le procédé comportant au moins une étape lors de laquelle on fait passer le faisceau d'exposition à travers un interféromètre (18) pour exposer la couche de matériau sensible selon un motif d'interférence, **caractérisé en ce qu'**on utilise un interféromètre équipé d'au moins deux réseaux périodiques de diffraction superposés ayant un pas et/ou une orientation différents pour former un réseau de franges de "moiré".

2. Procédé selon la revendication 1, dans lequel le faisceau d'exposition est un faisceau de photons.

3. Procédé selon la revendication 1, dans lequel le faisceau d'exposition est un faisceau d'électrons.

**4.** Procédé selon la revendication 1, comprenant en outre le développement de la couche (14) de matériau sensible pour former les motifs de lithographie selon le motif d'interférence.

**5.** Procédé selon la revendication 1, dans lequel on fait passer en outre le faisceau d'exposition à travers un masque (22) présentant des motifs d'exposition.

**6.** Dispositif de lithographie pour appliquer à une couche de matériau sensible (14) au moins un faisceau d'exposition (12), le dispositif comportant un interféromètre (18) disposé entre une source (10) du faisceau d'exposition et la couche de matériau sensible pour former dans la couche de matériau sensible un motif d'interférence, **caractérisé en ce que** l'interféromètre comporte au moins deux réseaux périodiques de diffraction superposés ayant un pas et/ou une orientation différents pour former un réseau de franges de "moiré".

**7.** Dispositif selon la revendication 6, dans lequel le faisceau d'exposition (12) est un faisceau de photons ou d'électrons.

**8.** Dispositif selon la revendication 7, dans lequel les réseaux périodiques de l'interféromètre (18) sont formés par les réseaux atomiques de matériaux cristallins.

**9.** Dispositif selon la revendication 8, dans lequel l'interféromètre (18) comporte des plaquettes de matériau cristallin à réseaux atomiques, présentant une orientation ajustable.

**10.** Dispositif selon la revendication 8, dans lequel l'interféromètre (18) comporte deux réseaux cristallins réalisés en un même matériau et dont l'un est soumis à une contrainte suffisante pour modifier son pas de réseau.

**11.** Dispositif selon la revendication 7, dans lequel la source (10) du faisceau d'exposition est une source de photons générés par un faisceau d'électrons d'un synchrotron.

**Claims**

**1.** Method of forming lithography patterns in a layer (14) of sensitive material by subjecting this layer to at least one exposure beam (12), the method comprising at least one step during which the exposure beam is passed through an interferometer (18) in order to expose the layer of sensitive material according to an interference pattern, **characterized in that** use is made of an interferometer equipped with at least two superimposed, periodic, diffraction gratings having a different pitch and/or a different orientation, in order to form a pattern of moiré fringes.

**2.** Method according to claim 1, in which the exposure beam is a beam of photons.

**3.** Method according to claim 1, in which the exposure beam is a beam of electrons.

**4.** Method according to claim 1, additionally comprising the development of the layer (14) of sensitive material to form the lithography patterns according to the interference pattern.

**5.** Method according to claim 1, in which, in addition, the exposure beam passes through a mask (22) which has exposure patterns.

**6.** Lithography device to apply at least one exposure beam (12) to a layer of sensitive material (14), the device comprising an interferometer (18) arranged between a source (10) of the exposure beam and the layer of sensitive material, in order to form an interference pattern in the layer of sensitive material, **characterized in that** the interferometer comprises at least two superimposed, periodic diffraction gratings having a different pitch and/or a different orientation, in order to form a pattern of moire fringes.

**7.** Device according to claim 6, in which the exposure beam (12) is a beam of photons or of electrons.

**8.** Device according to claim 7, in which the regular gratings of the interferometer (18) are formed by the atomic lattices of crystalline materials.

**9.** Device according to claim 8, in which the interferometer (18) comprises wafers of a crystalline material with atomic lattices that have an adjustable orientation.

10. Device according to claim 8, in which the interferometer (18) comprises two crystal lattices created in one and the same material, one of which is subjected to a stress sufficient to modify its lattice spacing.

11. Device according to claim 7, in which the source (10) for the exposure beam is a source of photons generated by a beam of electrons from a synchrotron.

**Patentansprüche**

1. Verfahren zur Bildung von Lithographiemustern in einer Schicht (14) aus sensiblem Material, indem man diese Schicht wenigstens einem Belichtungsstrahl (12) aussetzt, wobei das Verfahren wenigstens einen Schritt umfasst, während dem man den Belichtungsstrahl durch ein Interferometer (18) sendet, um die Schicht aus sensiblem Material mittels einem Interferenzmuster zu belichten,
   **dadurch gekennzeichnet,**
   **dass** man ein Interferometer verwendet, das mit wenigstens zwei überlagerten periodischen Diffraktionsgittern ausgerüstet ist, die eine unterschiedliche Teilung und/oder Ausrichtung haben, um ein Moiré-Streifen-Gitter zu bilden.

2. Verfahren nach Anspruch 1, bei dem der Belichtungsstrahl ein Photonenstrahl ist.

3. Verfahren nach Anspruch 1, bei dem der Belichtungsstrahl ein Elektronenstrahl ist.

4. Verfahren nach Anspruch 1, das außerdem die Entwicklung der Schicht (14) aus sensiblem Material umfasst, um die Lithographiemuster nach den Interferenzmustern zu bilden.

5. Verfahren nach Anspruch 1, bei dem man den Belichtungsstrahl außerdem durch eine Maske (22) sendet, die Belichtungsmuster aufweist.

6. Lithographievorrichtung, um eine Schicht aus sensiblem Material (14) mit wenigstens einem Belichtungsstrahl (12) zu belichten, wobei diese Vorrichtung ein Interferometer (18) umfasst, angeordnet zwischen einer Quelle (10) des Belichtungsstrahls und der Schicht aus sensiblem Material, um in der Schicht aus sensiblem Material ein Interferenzmuster zu bilden,
   **dadurch gekennzeichnet,**
   **dass** das Interferometer wenigstens zwei überlagerte periodische Diffraktionsgitter umfasst, die eine unterschiedliche Teilung und/oder Ausrichtung haben, um ein Moiré-Streifen-Gitter zu bilden.

7. Vorrichtung nach Anspruch 6, bei der der Belichtungsstrahl (12) ein Photonen- oder Elektronenstrahl ist.

8. Vorrichtung nach Anspruch 7, bei der die periodischen Gitter des Interferometers (18) durch die Atomgitter kristalliner Materialien gebildet werden.

9. Vorrichtung nach Anspruch 8, bei dem das Interferometer (18) Plättchen aus kristallinem Material mit Atomgittern umfasst, die eine verstellbare bzw. einstellbare Ausrichtung aufweisen.

10. Vorrichtung nach Anspruch 8, bei der das Interferometer (18) zwei aus einem selben Material realisierte Kristallgitter umfasst, von denen eines einer Spannung ausgesetzt wird, die ausreicht um seine Gitterteilung zu modifizieren.

11. Vorrichtung nach Anspruch 7, bei der die Quelle (10) des Belichtungsstrahls eine Photonenquelle ist, erzeugt durch einen Elektronenstrahl eines Synchrotrons.

FIG. 1

FIG. 3

FIG. 2A

10

12

18a

18

18b

12

22

14

20

16

FIG. 2B